# EUROPEAN PATENT APPLICATION

(11) **EP 4 414 755 A1**
(43) Date of publication of application: **14.08.2024**
(21) Application number: 22878495.5
(22) Date of filing: 04.10.2022
(51) Int. Cl.: G02B 5/20, F21S 2/00, F21V 9/32, G02B 5/02, G02F 1/13357, F21Y 115/10

(54) **WAVELENGTH CONVERSION SHEET-USE FILM, WAVELENGTH CONVERSION SHEET, BACKLIGHT, AND DISPLAY DEVICE**

(30) Priority: 08.10.2021 JP 2021166429
(71) Applicant: Dai Nippon Printing Co., Ltd., Tokyo 162-8001 (JP)
(72) Inventor: SAKAMOTO, Takeshi, Tokyo 162-8001 (JP); TAMURA, Shuichi, Tokyo 162-8001 (JP); HARUKI, Akihito, Tokyo 162-8001 (JP); YAMANISHI, Shota, Tokyo 162-8001 (JP); FUJIOKA, Yuko, Tokyo 162-8001 (JP); MORIMOTO, Taro, Tokyo 162-8001 (JP); ONO, Yoshiyuki, Tokyo 162-8001 (JP); HARADA, Ryutaro, Tokyo 162-8001 (JP)
(74) Representative: Beck Greener LLP
(86) International application number: PCT/JP2022/037050
(87) International publication number: WO 2023/058626

(57) **Abstract**

Provided are: a film for a wavelength conversion sheet having superior close adhesion to a phosphor layer when used for a wavelength conversion sheet, a wavelength conversion sheet having the film; and a backlight and a display device having the wavelength conversion sheet. A film (10) for a wavelength conversion sheet having: a base material (20); and a primer layer (30) on the base material (20), wherein the primer layer (30) includes a cured product of a resin composition including a polyurethane-based resin, and the cured product has a softening point of 250°C or higher.

## Description

### Technical Field

The present disclosure relates to a film used for a wavelength conversion sheet. The present disclosure also relates to a wavelength conversion sheet having the film, and a backlight and a display device including the wavelength conversion sheet.

### Background Art

In recent years, with the development of a personal computer, particularly the development of a portable personal computer, the demand for a liquid crystal display device has been increasing. In addition, recently, the penetration rate of a home-use liquid crystal television has also been increasing, and a smartphone and a tablet terminal have also been becoming widespread. Thus the market for a liquid crystal display device is in an expanding situation.

Such a liquid crystal display device generally has a liquid crystal cell unit having a color filter, opposed substrates, and a liquid crystal layer sandwiched between these, and further has a light source referred to as a backlight unit.

Recently, the development of a backlight member using quantum dot technology has also been promoted. The quantum dot refers to a nanometer-sized fine particle of a semiconductor. The quantum dot can be adjusted over the entire visible region of the emission wavelength by the quantum confinement effect (quantum size effect), in which an electron or an exciton is confined in a nanometer-sized small crystal. The quantum dot can generate strong fluorescence in a narrow wavelength band, and thus the display device can be illuminated with light of the three primary colors having excellent color purity. Therefore, a backlight using a quantum dot can provide a display device having excellent color reproducibility.

The wavelength conversion sheet used for the backlight source of this display device has a structure which has a phosphor layer obtained by dispersing a nanometer-sized phosphor fine particle of a semiconductor in a resin layer, and a film formed on a surface of the phosphor layer in order to protect the phosphor layer, in combination with an LED light source. This film has a water vapor barrier property in order to suppress degradation of the phosphor layer. For example, a wavelength conversion sheet obtained by laminating a barrier film on a phosphor layer containing a phosphor, and a backlight unit including the wavelength conversion sheet have been developed, wherein the barrier film is obtained by laminating a barrier layer on one surface of a predetermined polyethylene terephthalate film (PTL 1).

An attempt has been made to improve the close adhesion between the phosphor layer and the barrier film in order to further suppress the invasion of the phosphor layer by water vapor. For example, PTL 2 and PTL 3 each disclose a barrier film having excellent close adhesion to a phosphor layer even in a high temperature and high humidity environment by using a primer layer including a polyurethane-based resin composition.

### Citation List

### Patent Literature

PTL1: WO 2015/037733
PTL2: JP 2018-13724 A
PTL3: JP 2019-126924 A

### Summary of Invention

### Technical Problem

The wavelength conversion sheet of PTL 2 and 3 has excellent close adhesion to the phosphor layer even after a test of leaving under an environment at 60°C and 90%RH for 500 hours. However, further leaving under the environment causes peeling between the wavelength conversion sheet and the phosphor layer. There has been a problem that, by this peeling occurrence, oxygen and water vapor invade inside the wavelength conversion sheet to degrade the phosphor layer.

The present disclosure has been made in view of the above problem, and it is an object of the present disclosure to provide a film for a wavelength conversion sheet having superior close adhesion to the phosphor layer when used for a wavelength conversion sheet, a wavelength conversion sheet having the film, a backlight and a display device having the wavelength conversion sheet.

### Solution to Problem

On a film on which a primer layer is formed with various blending, the present inventors have evaluated correlation between properties thereof and close adhesion to a phosphor layer after a long-term environment test. As a result, the present inventors have found that, when a polyurethane-based resin composition to have a softening point of a cured product thereof being a predetermined value or higher is used, the excellent close adhesion to the phosphor layer can be achieved even with leaving under an environment at 60°C and 90%RH for longer than 500 hours, and completed the present disclosure.

That is, in order to solve the above problem, the present disclosure provides the following [1] to [10].
[1] A film for a wavelength conversion sheet, comprising: a base material; and a primer layer on the base material, wherein the primer layer comprises a cured product of a resin composition comprising a polyurethane-based resin, and the cured product has a softening point of 250°C or higher.
[2] The film for a wavelength conversion sheet according to [1], wherein the resin composition has a mole ratio of isocyanate groups to hydroxyl groups (NCO/OH ratio) of 1.1 or more.
[3] The film for a wavelength conversion sheet according to [1] or [2], wherein the polyurethane-based resin comprises a polyurethane-based resin obtained by a reaction between a polyfunctional isocyanate having a (meth)acryl group and a hydroxyl group-containing compound.
[4] The film for a wavelength conversion sheet according to any one of [1] to [3], wherein the resin composition comprises a silane coupling agent.
[5] The film for a wavelength conversion sheet according to any one of [1] to [4], further comprising a barrier layer between the base material and the primer layer.
[6] The film for a wavelength conversion sheet according to [5], wherein the barrier layer comprises an inorganic oxide layer and an organic coating layer, and the organic coating layer is in contact with the primer layer.
[7] The film for a wavelength conversion sheet according to [5], wherein the barrier layer is a layer comprising a reaction product of a composition comprising a metal oxide and a phosphorus compound.
[8] A wavelength conversion sheet, wherein the film according to any one of [1] to [7] is provided on at least one surface side of a phosphor layer comprising a phosphor such that the primer layer and the phosphor layer are in contact with each other.
[9] A backlight comprising: at least one light source that emits primary light; an optical plate that is disposed adjacent to the light source and is for light guiding or diffusion; and a wavelength conversion sheet disposed on a light emission side of the optical plate, wherein the wavelength conversion sheet is the wavelength conversion sheet according to [8].
[10] A display device comprising: a backlight; and a liquid crystal panel, wherein the backlight is the backlight according to [9].

### Advantageous Effects of Invention

According to the present disclosure, it is possible to obtain a wavelength conversion sheet that has excellent close adhesion to the phosphor layer even with leaving under a high-temperature high-humidity environment for a long term, and that can suppress degradation of the phosphor layer. Use of this wavelength conversion sheet can yield a backlight and a display device that hardly degrade the phosphor layer.

### Brief Description of Drawings

[Fig. 1] Fig. 1 is a cross-sectional schematic view schematically illustrating one embodiment of the film for a wavelength conversion sheet of the present disclosure.
[Fig. 2] Fig. 2 is a cross-sectional schematic view schematically illustrating one embodiment of the wavelength conversion sheet of the present disclosure.
[Fig. 3] Fig. 3 is a cross-sectional view showing one embodiment of the backlight of the present disclosure.
[Fig. 4] Fig. 4 is a cross-sectional view showing another embodiment of the backlight of the present disclosure.

### Description of Embodiments

Hereinafter, the film for a wavelength conversion sheet of the present disclosure will be described in detail. As used herein, the notation of the numerical range "AA to BB" means "AA or more and BB or less."

### [Film for wavelength conversion sheet]

The film for a wavelength conversion sheet plays roles of protecting the phosphor layer of the wavelength conversion sheet and preventing oxygen and water vapor from invading inside the wavelength conversion sheet to reach the phosphor layer from the external environment and causing degradation of the phosphor layer.

The film for a wavelength conversion sheet of the present disclosure has a base material; and a primer layer on the base material, wherein the primer layer contains a cured product of a resin composition including a polyurethane-based resin, and the cured product has a softening point of 250°C or higher.

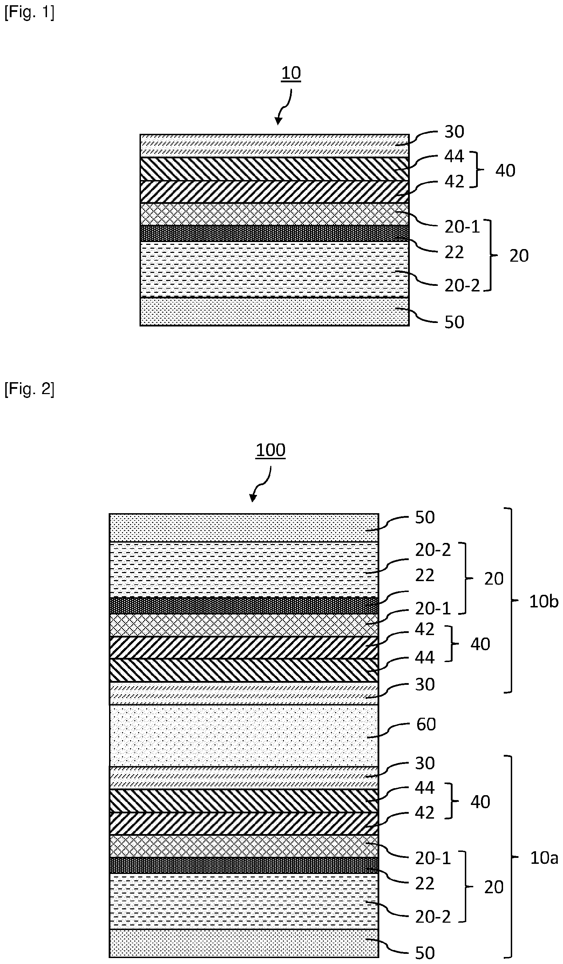

Fig. 1 is a cross-sectional schematic view schematically illustrating one embodiment of the film for a wavelength conversion sheet of the present disclosure. A film 10 for a wavelength conversion sheet has a primer layer 30 on a base material layer 20. As shown in Fig. 1, the film 10 for a wavelength conversion sheet may have a barrier layer 40 between the base material layer 20 and the primer layer 30. As shown in Fig. 1, a diffusion layer 50 may be provided on the surface of the opposite side of the base material layer 20 from the surface on which the primer layer 30 is formed.

The film for a wavelength conversion sheet of the present disclosure preferably has a high total light transmittance measured according to JIS K 7361-1:1997, in view of efficiently converting light from a light source when used for a wavelength conversion sheet. Specifically, the film for a wavelength conversion sheet of the present disclosure has a total light transmittance of preferably 85% or more, more preferably 90% or more, as measured according to JIS K 7361-1:1997.

A gas barrier property of the film for a wavelength conversion sheet of the present disclosure can be set according to requirement with considering degradation of the phosphor described later. Specifically, when the phosphor used for the wavelength conversion sheet has a property easy degradation by oxygen, water vapor, and the like, the film for a wavelength conversion sheet preferably has a high gas barrier property. On the other hand, when the phosphor is hardly degraded, a high gas barrier property is not required for the film for a wavelength conversion sheet.

The value of an oxygen transmission rate in accordance with JIS K 7129-2:2006 of the film for a wavelength conversion sheet is preferably 20 cc/m²·day·atm or less, more preferably 10 cc/m²·day·atm or less, further preferably 5 cc/m²·day·atm or less, and particularly preferably 2 cc/m²·day·atm or less. The value of a water vapor transmission rate of the film for a wavelength conversion sheet in accordance with JIS K 7129:2008 B method is preferably 20 g/m²·day or less, more preferably 10 g/m²·day or less, further preferably 5 g/m²·day or less, and particularly preferably 2 g/m²·day or less.

The oxygen transmission rate can be measured, for example, using an oxygen transmission rate measuring apparatus, "OX-TRAN," manufactured by MOCON, Inc. (MOCON method). The water vapor transmission rate can be measured, for example, using a water vapor transmission rate measuring apparatus, "PERMATRAN," manufactured by MOCON, Inc. The conditions for measuring the oxygen transmission rate are a temperature of 23°C and a relative humidity of 90%. The conditions for measuring the water vapor transmission rate are a temperature of 40°C and a relative humidity of 90%.

Hereinafter, each layer of the film for a wavelength conversion sheet will be described.

### [Base material layer]

The base material layer mainly plays the role of a support for the primer layer. The base material layer is preferably one having a high light-transmitting property. Specifically, the base material layer has a total light transmittance of preferably 85% or more, more preferably 90% or more, as measured according to JIS K 7361-1:1997.

The material of the base material layer is not particularly limited as long as it is a resin film that does not impair the function of the wavelength conversion sheet. Examples of the base material layer include a resin such as polyimide (PI), polyethylene naphthalate (PEN), polyethylene terephthalate (PET), polyethylene butyrate (PBT), polypropylene (PP), nylon resin, an amorphous polyarylate, polysulfone, polyethersulfone, polyetherimide, fluororesin, or a liquid crystal polymer. To obtain transparency, heat resistance, and the like, polyethylene naphthalate (PEN) or polyethylene terephthalate (PET) is preferably used as the base material layer. To obtain the aforementioned oxygen transmission rate and water vapor transmission rate, polyethylene terephthalate (PET), polyethylene naphthalate (PEN), polypropylene (PP), or nylon resin is preferably used as the base material layer.

The base material layer may be a resin film consisting of a single layer, or a plurality of resin films adhered via an adhesion layer. In the example shown in Fig. 1, in the base material layer 20, a first base material 20-1 and a second base material 20-2 are adhered to each other via an adhesion layer 22. In this case, the first base material 20-1 serves as a support for forming the primer layer 30. The second base material 20-2 plays the role of increasing the thickness of the entire base material layer 20 to impart rigidity to the film 10 for a wavelength conversion sheet.

The thickness of the entire base material layer is not particularly limited, and is preferably 8 µm or more and 200 µm or less, and more preferably 8 µm or more and 150 µm or less. When the film for a wavelength conversion sheet is produced by a winding method, the thickness of an entirety of the base material layer is preferably 125 µm or less. On the other hand, increasing the thickness of the entirety of the base material layer allows the base material layer to yield the gas barrier property against oxygen and water vapor. In this case, the barrier layer may be omitted. To achieve the required gas barrier property by the base material layer without providing the barrier layer, the thickness of the entirety of the base material layer is preferably 50 µm or more, and more preferably 75 µm or more.

When the base material layer is composed of a plurality of resin films, the thickness of the first base material serving as a support for the primer layer is preferably 8 µm or more and 50 µm or less, more preferably 8 µm or more and 25 µm or less, and further preferably 8 µm or more and 20 µm or less. When the first base material has the above thickness, the handleability is good when the primer layer is produced by the winding method. The thickness of the second base material is preferably 8 µm or more and 150 µm or less, and more preferably 8 µm or more and 100 µm or less. When the second base material has the above thickness, it is possible to impart appropriate rigidity to the film for a wavelength conversion sheet. Further, when the film for a wavelength conversion sheet is produced by the winding method, the handleability is good. When the gas barrier property is achieved by the base material layer as above, the thickness of the second base material is preferably 40 µm or more, and more preferably 50 µm or more.

The adhesive constituting the adhesion layer 22 is not particularly limited as long as it satisfies the good adhesiveness between the base material layers and the optical performance required for the wavelength conversion sheet. Examples of the adhesive that can be used include a polyvinyl acetate-based adhesive, a polyacrylic acid ester-based adhesive made of, for example, a homopolymer of an ethyl acrylate, butyl acrylate, 2-ethylhexyl acrylate or the like, or a copolymer of any of these with methyl methacrylate, acrylonitrile, styrene, or the like, a cyano acrylate-based adhesive, an ethylene copolymer-based adhesive made of, for example, a copolymer of ethylene with a monomer such as vinyl acetate, ethyl acrylate, acrylic acid, methacrylic acid, or the like, a cellulose-based adhesive, a polyester-based adhesive, a polyamide-based adhesive, a polyimide-based adhesive, an amino resin-based adhesive made of a urea resin, a melamine resin, or the like, a phenol resin-based adhesive, an epoxy-based adhesive, a polyurethane-based adhesive, a reactive (meth)acrylic-based adhesive, a rubber-based adhesive made of chloroprene rubber, nitrile rubber, styrenebutadiene rubber, or the like, a silicone-based adhesive, and an inorganic adhesive made of an alkali metal silicate, a low melting point glass, or the like. The composition system of the adhesive constituting the adhesive layer may be any composition form of an aqueous type, a solution type, an emulsion type, a dispersion type, and the like, and the form thereof may be any form of a film form, a sheet form, a powder form, a solid form, and the like, and further, the adhesion mechanism may be any form of a chemical reaction type, a solvent volatilization type, a hot-melt type, a hot-press type, and the like.

Instead of the above adhesive, an adhesion layer may be formed, for example, using a thermosetting resin or a resin obtained by containing a crosslinking agent or the like in a thermoplastic resin. Alternatively, the adhesion layer may be formed by extruding a thermoplastic resin such as EVA, an ionomer, polyvinyl butyral (PVB), or a polyethylenebased resin between base materials by extrusion lamination.

A desired surface treatment may be applied in advance to the surface of the side of the base material layer where the primer layer is to be provided, in order to improve the close adhesion to the primer layer or the barrier layer, or the like. Examples of the surface treatment include corona discharge treatment, ozone treatment, low temperature plasma treatment using oxygen gas, nitrogen gas, or the like, glow discharge treatment, and oxidation treatment using a chemical or the like.

As a method for improving the close adhesion to the primer layer or the barrier layer, an underlying layer such as an anchor coating agent layer or an adhesive layer may be formed in advance.

As the underlying layer, a resin composition containing a polyester-based resin, a polyamide-based resin, a polyurethane-based resin, an epoxy-based resin, a phenol-based resin, a (meth)acrylic-based resin, a polyvinyl acetate-based resin, a polyolefin-based resin such as polyethylene or polypropylene or a copolymer or a modified resin thereof, a cellulose-based resin, or the like as the main component of the vehicle can be used.

### [Barrier layer]

The barrier layer is a layer that imparts a gas barrier property to the film for a wavelength conversion sheet. The barrier layer is a layer optionally provided according to the gas barrier property required for the film for a wavelength conversion sheet. The barrier layer may be provided on an opposite side to the primer layer of the base material layer, or may be provided between the base material layer and the primer layer. To prevent damage of the barrier layer during a manufacturing process of the film for a wavelength conversion sheet and a manufacturing process of the wavelength conversion sheet, or to inhibit degradation of the phosphor layer from the sheet edge when used for the wavelength conversion sheet, the barrier layer is preferably provided between the base material layer and the primer layer.

In the example shown in Fig. 1, the barrier layer 40 is configured by laminating an inorganic oxide layer 42 and an organic coating layer 44 in the order from the base material layer 20 side. The organic coating layer 44 is in contact with the primer layer 30.

The barrier layer of the present disclosure is not limited to the laminated configuration shown in Fig. 1. Examples of a layer to configure the barrier layer include "inorganic oxide layer formed by vapor-depositing an inorganic oxide," "inorganic oxide layer formed by a sol-gel method," "organic coating layer formed by applying a coating agent containing a water-soluble polymer and the like such as polyvinyl alcohol," and "layer containing a reaction product of a composition including a metal oxide and a phosphorus compound (hereinafter, referred to as "metal-phosphoric acid reaction product layer." Examples of the configuration of the barrier layer in the present disclosure include a single layer of a single type selected from the group consisting of these layers, a layer in which a plurality of layers of a single type selected from the above group is laminated, and layers in which layers of two or more types selected from the above group are alternately laminated. Among these, a configuration in which the inorganic oxide layer and the organic coating layer are laminated as shown in Fig. 1, or a single-layer configuration of the metal-phosphoric acid reaction product layer is preferable.

### <Inorganic oxide layer>

Examples of the inorganic oxide layer include a layer made of aluminum oxide, silicon oxide, magnesium oxide, or a mixture thereof. The inorganic oxide layer is preferably a thin film layer containing aluminum oxide or silicon oxide as a main component, in view of a gas barrier property, transparency, productivity, or the like.

Examples of the method for forming the inorganic oxide layer include a forming method by vapor-depositing an inorganic oxide and a forming method by a sol-gel method. Examples of the method for forming a vapor-deposited film include a physical vapor deposition method (PVD method) such as a vacuum vapor deposition method, a sputtering method, and an ion plating method, or a chemical vapor deposition method (CVD method) such as a plasma chemical vapor deposition method, a thermochemical vapor deposition method, and a photochemical vapor deposition method.

The thickness of the inorganic oxide layer is not particularly limited, and is preferably 5 nm or more and 500 nm or less. When the thickness of the inorganic oxide layer is 5 nm or more, the inorganic oxide layer becomes uniform, and a sufficient gas barrier property can be imparted to the film for a wavelength conversion sheet. The thickness of the inorganic oxide layer is more preferably 8 nm or more and further preferably 10 nm or more, in consideration of the gas barrier property. When the thickness of the inorganic oxide layer is 500 nm or less, sufficient flexibility can be imparted to the inorganic oxide layer, and it is possible to reduce the occurrence of a scratch and a crack in each inorganic oxide layer. The thickness of the inorganic oxide layer is more preferably 100 nm or less, further preferably 50 nm or less, and particularly preferably 20 nm or less, in consideration of transparency, productivity, and the like. When a plurality of inorganic oxide layers are provided, the thickness of each inorganic oxide layer is preferably in the above thickness range.

### < Organic coating layer>

The organic coating layer is a layer that prevents various types of secondary damage in a subsequent step and imparts a high gas barrier property to the film for a wavelength conversion sheet. By locating the inorganic oxide layer between the base material layer and the organic coating layer, the occurrence of a scratch or a crack in the inorganic oxide layer can be reduced. By providing the organic coating layer in contact with the primer layer, the close adhesion between the primer layer and the barrier layer of the present disclosure can be improved.

For example, using a gas barrier composition including a water-soluble polymer and an aqueous solution or a water/alcohol mixed solution including at least one of one or more metal alkoxides and hydrolysates or tin chloride as a coating liquid, the organic coating layer is formed by applying the coating liquid. The organic coating layer preferably contains at least one selected from the group consisting of a hydroxyl group-containing polymer compound, a metal alkoxide, a metal alkoxide hydrolysate, and a metal alkoxide polymer as a component. Examples of the water-soluble polymer used for the organic coating layer include polyvinyl alcohol, polyvinylpyrrolidone, and an ethylene-vinyl alcohol copolymer. In particular, when polyvinyl alcohol and/or an ethylene-vinyl alcohol copolymer is used, an excellent gas barrier property can be obtained. The content of the polyvinyl alcohol-based resin and/or the ethylene-vinyl alcohol copolymer is preferably in the range of 5 parts by mass or more and 500 parts by mass or less, and more preferably in the range of 20 parts by mass or more and 200 parts by mass or less, per 100 parts by mass in total of the above alkoxides.

A silane coupling agent or the like can also be added to the gas barrier composition. As the silane coupling agent, a known organic reactive group-containing organoalkoxysilane can be used. In the present disclosure, an organoalkoxysilane having an epoxy group is particularly preferable, and examples thereof that can be used include γ-glycidoxypropyltrimethoxysilane, γ-glycidoxypropylmethyldiethoxysilane, or β-(3,4-epoxycyclohexyl)ethyltrimethoxysilane. Such silane coupling agents may be used singly or as a mixture of two or more. In the present disclosure, the amount of such a silane coupling agent used is preferably 1 part by mass or more and 20 parts by mass or less per 100 parts by mass of the above alkoxysilane.

The thickness of the organic coating layer is not particularly limited, and is preferably 100 nm or more and 500 nm or less. When the thickness of the organic coating layer is 100 nm or more, a sufficient gas barrier property can be imparted to the film for a wavelength conversion sheet. The thickness of the organic coating layer is more preferably 120 nm or more, and further preferably 150 nm or more, in consideration of the gas barrier property. When the thickness of the organic coating layer is 500 nm or less, sufficient transparency can be ensured. The thickness of the organic coating layer is more preferably 300 nm or less, and further preferably 200 nm or less, in consideration of transparency, productivity, or the like. When a plurality of organic coating layers are provided, the thickness of each organic coating layer is preferably in the above thickness range.

### <Metal-phosphoric acid reaction product layer>

Examples of the layer including the reaction product of the composition including the metal oxide and the phosphorus compound (metal-phosphoric acid reaction product layer) include a layer described in WO 2011/122036. The metal is preferably aluminum.

A thickness of the metal-phosphoric acid reaction product layer is not particularly limited, but preferably 100 nm or more and 2000 nm or less. When the thickness of the metal-phosphoric acid reaction product layer is 100 nm or more, a sufficient gas barrier property can be imparted to the film for a wavelength conversion sheet. With considering the gas barrier property, the thickness of the metal-phosphoric acid reaction product layer is more preferably 200 nm or more, and further preferably 300 nm or more. When the thickness of the metal-phosphoric acid reaction product layer is 2,000 nm or less, film cracking during the film formation can be suppressed. With considering bending resistance or the like, the thickness of the metal-phosphoric acid reaction product layer is more preferably 1,000 nm or less, and further preferably 900 nm or less.

### [Primer layer]

The primer layer plays the role of ensuring good close adhesion to the phosphor layer when used for a wavelength conversion sheet to prevent the separation between the film for a wavelength conversion sheet and the phosphor layer even in a high temperature and high humidity environment and prevent degradation of the phosphor layer.

In the present disclosure, the primer layer contains a cured product of a resin composition including a polyurethane-based resin. When a urethane bond is detected by X-ray photoelectron spectroscopy (XPS), infrared spectroscopy (IR), nuclear magnetic resonance (NMR), gas chromatography-mass spectrometry (GCMS), or the like, it can be determined that the primer layer includes a polyurethane-based resin.

In the present disclosure, a softening point of the cured product of the resin composition constituting the primer layer is 250°C or higher. The softening point of the cured product is a value measured by local thermal analysis using a thermal probe.

In the local thermal analysis using the thermal probe, deflection of the thermal probe from before heating is measured while raising a temperature in a state where the thermal probe is contacted with a surface of the primer layer to obtain a thermal expansion curve. Specifically, the resin of the primer layer is expanded by heating to push up the thermal probe. When the resin of the primer layer is softened, a tip of the thermal probe is inserted into the resin, and thereby the thermal probe is lowered. A point where the deflection of the thermal probe is converted from raising to lowering corresponds to a peak of the thermal expansion curve. A temperature at the peak of the thermal expansion curve is defined as the softening point of the cured product of the resin composition constituting the primer layer. In the present invention, the softening point is an average value of values measured at any ten positions on the primer layer surface.

When the primer layer contains the cured product of the resin composition including the polyurethane-based resin, peel strength between the primer layer and the phosphor layer becomes high when used as the wavelength conversion sheet, and close adhesion before exposure to a high-temperature high-humidity environment (which may be referred to as "initial close adhesion") becomes good.

When the softening point of the cured product of the resin composition constituting the primer layer is lower than 250°C, the initial close adhesion is good but peeling occurs between the primer layer and the phosphor layer by leaving under a high-temperature high-humidity environment (for example, 60°C and 90%RH). That is, the close adhesion (which may be referred to as "close adhesion with time," "temporal close adhesion," or the like) is decreased by leaving under the high-temperature high-humidity environment. When the softening point of the cured product of the resin composition constituting the primer layer is 250°C or higher, the decrease in the peel strength, namely the decrease in the temporal close adhesion, can be suppressed even by leaving under the high-temperature high-humidity environment for a long term of longer than 500 hours. The softening point is preferably 270°C or higher, and more preferably 280°C or higher.

The effect of the softening point of the cured product of the resin composition constituting the primer layer on the peeling state (close adhesion) between the primer layer and the phosphor layer when exposed to the high-temperature high-humidity environment is presumed as follows.

First, the initial close adhesion is presumed as follows. The phosphor layer of the wavelength conversion sheet is formed by applying a resin composition to be a precursor of the phosphor layer on the primer layer surface of the film for a wavelength conversion sheet, and curing the resin composition, as described later. On the side of the phosphor layer of the primer layer, contraction stress is generated with contraction of the phosphor layer. On the other hand, since the opposite side to the phosphor layer of the primer layer is contacted with the base material layer or the barrier layer, the contraction stress is not generated in curing the phosphor layer. That is, formation of the phosphor layer causes stress distribution in a thickness direction of the primer layer to generate strain inside the primer layer. When the initial close adhesion between the phosphor layer and the primer layer is weak, the peeling occurs between the phosphor layer and the primer layer due to the effect of the strain inside the primer layer.

When the wavelength conversion sheet is left under the high-temperature high-humidity environment for a long term, the resin composition constituting the primer layer is affected by heat and water vapor even with the softening point higher than the environmental temperature. When the softening point of the cured product is lower than 250°C, the properties of the resin easily change due to heat and water vapor. As the change in the properties of the resin, hydrolysis and softening of the polyurethane-based resin are considered. Therefore, it is considered that, even with the good initial close adhesion, stress balance inside the primer layer is changed or the primer layer is degraded on the interface with the phosphor layer to decrease the close adhesion, resulting in the peeling. On the other hand, since the properties of the resin hardly changes when the softening point of the cured product is 250°C or higher, the change in the stress balance and the degradation of the primer layer are suppressed. As a result, it is considered that, even when the wavelength conversion sheet is left under the high-temperature high-humidity environment, the high close adhesion between the phosphor layer and the primer layer can be retained.

The polyurethane-based resin composition includes a one-pack or two-pack polyurethane-based resin obtained by reacting a polyfunctional isocyanate with a hydroxyl group-containing compound.

The softening point of the cured product of the resin composition constituting the primer layer can be varied by changing a combination of the polyfunctional isocyanate and the hydroxyl group-containing compound, a blending ratio between the polyfunctional isocyanate and the hydroxyl group-containing compound, a combination of a plurality of the hydroxyl group-containing compounds having different softening points and a blending ratio thereof, the NCO/OH ratio in the polyurethane-based resin, the molecular weight of the polyurethane-based resin, and the like. The softening point of the cured product of the resin composition constituting the primer layer can also be varied by adding an adhesion-imparting resin (tackifier) having a different softening point from the polyurethane-based resin.

Only one of each of the polyfunctional isocyanate and the hydroxyl group-containing compound may be used, or a plurality of each thereof may be used.

Specific examples of the polyfunctional isocyanate include an aromatic polyisocyanate such as tolylene diisocyanate, diphenylmethane diisocyanate, xylylene diisocyanate, or polymethylene polyphenylene polyisocyanate, and an aliphatic polyisocyanate such as hexamethylene diisocyanate or isophorone diisocyanate. The polyfunctional isocyanate may be used as a modified derivative with an increased molecular weight, such as an adduct derivative, a biuret derivative, and an isocyanurate derivative, or may be used as a block derivative. The modified derivative and the block derivative may have a functional group such as a hydroxyl group, a carboxyl group, an epoxy group, an amino group, a mercapto group, a vinyl group, an acryloyl group, and a methacryloyl group. Among these, a (meth)acryl-group-containing polyisocyanate is preferably used. That is, the polyurethane-based resin of the present disclosure includes a polyurethane-based resin obtained by a reaction between a polyfunctional isocyanate having a (meth)acryl group and the hydroxyl group-containing compound.

Examples of the hydroxyl group-containing compound include a polyether polyol, a polyester polyol, a polyester polyurethane polyol, and a polyacrylate polyol.

The NCO/OH ratio is preferably 1.1 or more, more preferably 1.2 or more, and further preferably 1.3 or more. When the NCO/OH ratio is 1.1 or more, the initial close adhesion becomes excellent, and the softening point is easily 250°C or higher. Note that, when the NCO/OH ratio is high, the primer layer has tackiness. Thus, the NCO/OH ratio is preferably 4.0 or less, and more preferably 3.0 or less.

Although depending on the types of the polyfunctional isocyanate and the hydroxyl group-containing compound, a large molecular weight of the polyurethane-based resin raises the softening point of the polyurethane-based resin, and as a result, the softening point of the cured product of the resin composition is easily 250°C or higher. The molecular weight (weight average molecular weight) of the polyurethane-based resin is preferably 100 or more and 100,000 or less.

A cured product of the polyurethane-based resin composition is contained in an amount of preferably 40% by mass or more, and more preferably 70% by mass or more, based on the total amount of the primer layer. When the polyurethane-based resin is contained at 40% by mass or more, the initial close adhesion and temporal close adhesion between the primer layer and the phosphor layer can be improved.

In the present disclosure, the primer layer preferably further contains a silane coupling agent. When the silane coupling agent is included, the silane coupling agent has an effect of suppressing decrease in the temporal close adhesion due to hydrolysis of the urethane bond in the polyurethane-based resin by leaving under the high-temperature high-humidity environment for a long time. In the configuration of providing the barrier layer, the silane coupling agent can also improve the close adhesion between the primer layer and the barrier layer (specifically, the organic coating layer).

In the silane coupling agent, a functional group present at one end of the molecule thereof, usually a chloro, alkoxy, acetoxy group or the like, is hydrolyzed to form a silanol group (Si-OH), whereby the resin composition of the primer layer is modified by a covalent bond or the like to form a strong bond. Thus, it is considered that the hydrolysis of the urethane bond under the high-temperature high-humidity environment can be suppressed to suppress the decrease in the close adhesion with time. In addition, an organic functional group such as vinyl, methacryloxy, amino, epoxy, or mercapto, which is present on the other end in the silane coupling agent can improve the close adhesion between the primer layer and the phosphor layer and the close adhesion between the barrier layer and the primer layer.

As the silane coupling agent, an organofunctional silane monomer having binary reactivity can be used, and, for example, one or more of aqueous solutions can be used, the aqueous solution including γ-chloropropyltrimethoxysilane, vinyltrichlorosilane, vinyltriethoxysilane, vinyl-tris(β-methoxyethoxy)silane, γ-methacryloxypropyltrimethoxysilane, β-(3,4-epoxycyclohexyl)ethyltrimethoxysilane, γ-glycidoxypropyltrimethoxysilane, vinyltriacetoxysilane, γ-mercaptopropyltrimethoxysilane, N-β(aminoethyl)-γ-aminopropyltrimethoxysilane, N-β(aminoethyl)-γ-aminopropylmethyldimethoxysilane, γ-ureidopropyltriethoxysilane, bis(β-hydroxyethyl)-γ-aminopropyltriethoxysilane, γ-aminopropylsilicone, or the like.

The silane coupling agent is contained in an amount of preferably 1% by mass or more, and more preferably 2% by mass or more, based on the total amount of the primer layer. When the content of the silane coupling agent is within the above range, the initial close adhesion between the primer layer and the phosphor layer and the close adhesion between the barrier layer and the primer layer can be further improved. In addition, the good close adhesion between the primer layer and the phosphor layer can be retained over time. In view of improving the extensibility of the primer layer and suppressing the occurrence of a crack in the primer layer, the silane coupling agent is contained in an amount of preferably 30% by mass or less, and more preferably 20% by mass or less, based on the total amount of the primer layer.

In the present disclosure, the surface of the primer layer (surface that comes into contact with the phosphor layer) may further be subjected to a surface treatment such as corona discharge treatment, ozone treatment, low temperature plasma treatment using oxygen gas, nitrogen gas, or the like, glow discharge treatment, or oxidation treatment using a chemical or the like, after the primer layer is formed.

In the present disclosure, the primer layer may further include a filler. The filler has the role of adjusting the viscosity or the like of a coating liquid for primer layer formation to improve the coating suitability or the like. As the filler, for example, powders such as calcium carbonate, barium sulfate, alumina white, silica, talc, a glass frit, or a resin powder can be used.

The primer layer may further include an additive such as a stabilizer, a crosslinking agent, a lubricant, or an ultraviolet absorber, as necessary.

The thickness of the primer layer is not particularly limited, and is preferably 0.05 µm or more, and more preferably 0.1 µm or more. To reduce the strain inside the primer layer, the relatively thick primer layer is preferable. However, when the primer layer is too thick, handleability and productivity decrease. Thus, the thickness of the primer layer is preferably 10 µm or less, and more preferably 3 µm or less.

The primer layer according to the present embodiment preferably has a high total light transmittance measured according to JIS K 7361-1:1997, in view of efficiently converting light from a light source. Specifically, the primer layer according to the present embodiment has a total light transmittance of preferably 85% or more, and more preferably 90% or more, as measured according to JIS K 7361-1:1997, when the primer layer is formed on a PET film (film thickness: 12 µm).

### [Diffusion layer]

The diffusion layer is a layer provided for the purpose of reducing the anisotropy of the light exit angle distribution and preventing sticking, and is a layer optionally provided in the present disclosure.

The diffusion layer includes a binder resin and a filler. The filler itself is embedded in the binder resin, and at least a part of the filler is exposed from the binder resin to the surface side of the layer to give an uneven shape to the surface of the diffusion layer, whereby the effect of reducing the anisotropy of the light exit angle distribution is exhibited.

Further, because the surface of the diffusion layer has an uneven shape, it has the role of preventing sticking even if films for a wavelength conversion sheet or wavelength conversion sheets come into contact with each other in the production process of the films for a wavelength conversion sheet or the wavelength conversion sheets. For example, when a film for a wavelength conversion sheet or a wavelength conversion sheet is produced by a winding method, the film for a wavelength conversion sheet or the wavelength conversion sheet can be easily handled and a surface scratch can be suppressed. In addition, when the diffusion layer is used for a display device, the diffusion layer also has the role of preventing the sticking between the light guide plate or the diffusing plate and the wavelength conversion sheet, and also exhibits the effect of suppressing the occurrence of a scratch due to rubbing between the light guide plate or the diffusing plate and the wavelength conversion sheet to reduce the occurrence of poor appearance of the display device.

The binder resin of the diffusion layer is not particularly limited as long as it meets the specifications required for the film for a wavelength conversion sheet and the wavelength conversion sheet. Examples thereof that can be used include an acrylic-based resin, an epoxy resin, a urethane resin, a polyester-based resin, a polyester acrylate-based resin, a polyurethane acrylate-based resin, an acrylic urethane-based resin, and an epoxy acrylate-based resin. The binder resin is preferably an acrylic-based resin in view of having high hardness.

The filler is preferably a resin filler in view of the optical performance required for the film for a wavelength conversion sheet and the wavelength conversion sheet. Examples of the resin used for the filler include an acrylic-based resin and a polystyrene-based resin. An acrylic-based resin filler is particularly preferable in view of improving the scratch resistance of the diffusion layer. The acrylic-based resin here is a polymer including an ethylenically unsaturated monomer having at least one carboxyl group or carboxylic acid ester group selected from the group consisting of methacrylic acid, acrylic acid, a methacrylic acid ester, and an acrylic acid ester as a monomer component.

The difference in refractive index between the refractive index of the filler and the refractive index of the resin binder is preferably 0.5 or less, more preferably 0.3 or less, and further preferably 0.1 or less.

The average particle size of the filler is preferably 1 µm or more and 50 µm or less, and more preferably 1.5 µm or more and 10 µm or less. When the average particle size of the filler is 1 µm or more, at least a part of the filler is exposed more from the surface of the diffusion layer, which can give appropriate light diffusivity and suppress sticking more effectively. When the average particle size of the filler is 50 µm or less, the filler is less likely to be detached from the diffusion layer, and it is possible to suppress functional deterioration of the diffusion layer and a scratch caused by the detached filler.

In the present disclosure, the average particle size means a mass-averaged value d50 in the particle size distribution measurement by a laser-light diffraction method.

The content of the filler is preferably 5% by mass or more and 50% by mass or less, and more preferably 10% by mass or more and 40% by mass or less, based on the total amount of the diffusion layer. When the content thereof is 5% by mass or more, it is possible to provide appropriate light diffusivity and effectively prevent sticking. When the content thereof is 50% by mass or less, it is easy to satisfy the optical characteristics required for the film for a wavelength conversion sheet and the wavelength conversion sheet, and further, it is also possible to improve the film forming property of the diffusion layer.

The diffusion layer may optionally include an additive such as a stabilizer, a curing agent, a crosslinking agent, a lubricant, or an ultraviolet absorber, as necessary.

The thickness of the diffusion layer is not particularly limited, and can be appropriately set according to the average particle size of the filler, the specifications required for the film for a wavelength conversion sheet and the wavelength conversion sheet, or the like. For example, the thickness of the diffusion layer is preferably 1.0 µm or more and 50.0 µm or less, and more preferably 1.5 µm or more and 10.0 µm or less. The thickness of the diffusion layer means the thickness of the resin portion other than the filler in the diffusion layer, and does not include that of a portion of the filler projecting on the resin. The thickness of a diffusion prevention layer can be measured, for example, by observing a cross section using a scanning electron microscope or the like.

### [Method for producing film for wavelength conversion sheet]

The film for a wavelength conversion sheet of the present disclosure is produced by the following steps.

### (1) Barrier layer formation step

The barrier layer is formed on one surface of a base material layer (or a first base material). The barrier layer formation step may be omitted.

When the organic coating layer and the inorganic oxide layer are the barrier layer as exemplified in Fig. 1, the inorganic oxide layer is firstly formed on the base material layer (or the first base material), and the organic coating layer is formed on the inorganic oxide layer.

The surface of the base material layer (or the first base material) on which the barrier layer is formed may be subjected to the above surface treatment in advance, or on the surface thereof, an underlying layer may be formed.

The inorganic oxide layer can be formed by vapor deposition or a sol-gel method. Examples of the method for vapor-depositing an inorganic oxide include a physical vapor deposition method (PVD method) such as a vacuum vapor deposition method, a sputtering method, and an ion plating method, or a chemical vapor deposition method (CVD method) such as a plasma chemical vapor deposition method, a thermochemical vapor deposition method, and a photochemical vapor deposition method.

The organic coating layer can be formed by applying a coating agent including the above gas barrier composition and curing the applied coating agent by heating. The coating agent is prepared by adding a solvent or the like to the gas barrier composition such that the desired gas barrier property, thickness, viscosity, or the like can be obtained. Examples of the method for applying the coating agent include an application method of roll coating, gravure coating, knife coating, dip coating, spray coating, or another coating method.

The metal-phosphoric acid reaction product layer can be formed by a method described in WO 2011/122036.

### (2) Primer layer formation step

A primer layer is formed on the base material layer or the barrier layer. The primer layer can be formed by applying a coating agent of the resin composition including the above polyurethane-based resin and curing the applied coating agent by heating. The coating agent is prepared by adding a solvent or the like to the coating agent such that thickness, viscosity, or the like can be obtained. Examples of the method for applying the coating agent include an application method of roll coating, gravure coating, knife coating, dip coating, spray coating, or another coating method. The heating temperature is preferably within a range of 50°C or higher and 180°C or lower.

When the base material layer is formed by laminating a plurality of base materials as shown in Fig. 1, the method for producing the film for a wavelength conversion sheet of the present disclosure further includes (3) an adhesion step after the primer layer formation step (2).

### (3) Adhesion step

In the adhesion step, the surface of the opposite side of the first base material from the barrier layer and the second base material are laminated via an adhesion layer.

Specifically, the above adhesive is applied to the surface of the first base material, the second base material is overlapped, and the adhesion layer is cured. Alternatively, a coating agent including a crosslinking agent and a resin is applied to the surface of the first base material, then the second base material is overlapped, and the coating agent is crosslinked by heat or the like. The method for applying an adhesive or a coating agent can be applied by roll coating, gravure coating, knife coating, dip coating, spray coating, another coating method, a printing method, or the like.

Alternatively, a melted thermoplastic resin may be caused to flow between the first base material and the second base material by extrusion lamination, and then cooled to form an adhesion layer.

When a diffusion layer is provided as shown in Fig. 1, the diffusion layer is preferably formed in advance on the base material layer or the second base material.

Specifically, a coating agent including a resin, a filler, a solvent, and the like can be applied to the surface of the opposite side of the base material layer or the second base material from the surface on which the barrier layer is provided, and cured to form the diffusion layer. Examples of the method for applying the coating agent include an application method of roll coating, gravure coating, knife coating, dip coating, spray coating, or another coating method.

### [Applications of film for wavelength conversion sheet]

The film for a wavelength conversion sheet according to the present disclosure can be used, for example, as a film for a wavelength conversion sheet for a wavelength conversion sheet of a surface light source. Examples of the surface light source include a backlight light source of a display device such as a liquid crystal display device and a backlight light source of an inspection device. That is, the film for a wavelength conversion sheet according to the present disclosure can be used as a "film for a wavelength conversion sheet for a wavelength conversion sheet of a backlight light source of a display device," a "film for a wavelength conversion sheet for a wavelength conversion sheet of a backlight light source of an inspection device," or the like.

Further, the film for a wavelength conversion sheet according to the present disclosure can also be used as a "film for a wavelength conversion sheet for a wavelength conversion sheet for horticulture." Examples of the wavelength conversion sheet for horticulture include a sheet having the function of converting an ultraviolet ray into a wavelength suitable for plant growth. Examples of the wavelength suitable for plant growth include a wavelength suitable for photosynthesis. The wavelength conversion sheet for horticulture can be installed, for example, on a ceiling or the like of a horticultural facility such as a plastic greenhouse and a glasshouse.

### [Wavelength conversion sheet]

Fig. 2 is a cross-sectional schematic view schematically illustrating one embodiment of the wavelength conversion sheet of the present disclosure. A wavelength conversion sheet 100 in Fig. 2 has the films 10 (10a, 10b) for a wavelength conversion sheet illustrated in Fig. 1 on both surfaces of a phosphor layer 60. The configuration of the wavelength conversion sheet of the present disclosure is not limited to that in Fig. 2. The wavelength conversion sheet of the present disclosure may have, for example, the film for a wavelength conversion sheet illustrated in Fig. 1 on one surface side, and the film for a wavelength conversion sheet of the present disclosure having another lamination configuration on the other surface side. Examples of the film for a wavelength conversion sheet of the present disclosure having another lamination configuration include a film for a wavelength conversion sheet in which the barrier layer is not formed, and a film for a wavelength conversion sheet in which the barrier layer has a difference configuration.

The film 10 for a wavelength conversion sheet of the present disclosure is provided on at least one surface side of the phosphor layer 60. That is, the film 10 (10a) for a wavelength conversion sheet of the present disclosure may be provided on one surface side of the phosphor layer 60, and a film for a wavelength conversion sheet other than the aforementioned film for a wavelength conversion sheet of the present disclosure may be provided on the other surface side of the phosphor layer 60.

### [Phosphor layer]

The phosphor layer is a layer for adjusting the emission wavelength of light emitted from a backlight source. The phosphor layer can be formed by laminating a sealing resin containing a phosphor. For example, the phosphor layer can be formed by applying a liquid mixture containing a phosphor and a sealing resin to a surface of a base material layer and curing the applied liquid mixture. The phosphor layer contains one or two or more phosphors formed of a quantum dot.

The quantum dot forming the phosphor is a semiconductor particle of a predetermined size having the quantum confinement effect. When a quantum dot absorbs light from an excitation source and reaches an energy excited state, the quantum dot emits energy corresponding to an energy bandgap of the quantum dot. By regulating the size of the quantum dot or the composition of the substance, the energy bandgap can be regulated, and energy of wavelength bands at various levels can be obtained. In particular, the quantum dot can generate strong fluorescence in a narrow wavelength band. Therefore, the display device can be illuminated with light of the three primary colors having excellent color purity, and thereby the display device can have excellent color reproducibility.

The quantum dot preferably includes a quantum dot that emits secondary light having a wavelength corresponding to red, a quantum dot that emits secondary light having a wavelength corresponding to green, and a combination thereof. The quantum dot may contain a quantum dot other than the quantum dot that emits secondary light having a wavelength corresponding to red and the quantum dot that emits secondary light having a wavelength corresponding to green.

The core of the quantum dot is not particularly limited as long as it is a nanometer-sized fine particle of a semiconductor and is a material that generates the quantum confinement effect (quantum size effect). Examples of the quantum dot include a semiconductor fine particle whose emission color is regulated by its own particle size and a semiconductor fine particle having a dopant.

Specific examples of a material that forms the core include a semiconductor crystal containing a semiconductor compound or a semiconductor such as a group II-VI semiconductor compound such as MgS, MgSe, MgTe, CaS, CaSe, CaTe, SrS, SrSe, SrTe, BaS, BaSe, BaTe, ZnS, ZnSe, ZnTe, CdS, CdSe, CdTe, HgS, HgSe, and HgTe; a group III-V semiconductor compound such as AlN, AlP, AlAs, AlSb, GaAs, GaP, GaN, GaSb, InN, InAs, InP, InSb, TiN, TiP, TiAs, and TiSb; or a group IV semiconductor such as Si, Ge, and Pb. A semiconductor crystal including a semiconductor compound including three or more elements such as InGaP can also be used.

Further, as a quantum dot composed of a semiconductor fine particle having a dopant, a semiconductor crystal can be used that is formed by doping the above semiconductor compound with a cation of a rare earth metal or a cation of a transition metal, such as Eu³⁺, Tb³⁺, Ag⁺, or Cu⁺.

A semiconductor crystal such as CdS, CdSe, CdTe, InP, or InGaP is suitable as a material that forms the core of the quantum dot in view of ease of preparation, controllability of particle size that can provide light emission in the visible range, and fluorescence quantum yield.

The quantum dot may be made of one semiconductor compound or two or more semiconductor compounds. For example, the quantum dot may have a structure (core-shell structure) in which the core as a light emitting portion is covered with a protective layer (shell).

When the core-shell type quantum dot is used, a material having a bandgap higher than that of the semiconductor compound that forms the core can be used as the semiconductor that forms the shell so that an exciton is confined in the core, whereby the light emission efficiency of the quantum dot can be enhanced.

Examples of the core-shell structure (core/shell) having such a bandgap magnitude relationship include CdSe/ZnS, CdSe/ZnSe, CdSe/CdS, CdTe/CdS, InP/ZnS, Gap/ZnS, Si/ZnS, InN/GaN, InP/CdSSe, InP/ZnSeTe, InGaP/ZnSe, InGaP/ZnS, Si/AlP, InP/ZnSTe, InGaP/ZnSTe, and InGaP/ZnSSe.

The size of the quantum dot may be appropriately controlled by the material that constitutes the quantum dot so that light having a desired wavelength can be obtained. As the particle size of the quantum dot decreases, the energy bandgap increases. Specifically, as the crystal size decreases, the light emission of the quantum dot shifts to the blue side, that is, to the high energy side.

In general, the particle size (diameter) of the quantum dot is preferably in the range of 0.5 nm or more and 20 nm or less and particularly preferably in the range of 1 nm or more and 10 nm or less. A narrower size distribution of the quantum dot can provide a clearer emission color.

The shape of the quantum dot is not particularly limited, and may be, for example, a spherical shape, a rod shape, a disk shape, or any other shape. When the quantum dot is not in a spherical shape, the particle size of the quantum dot can be a value of a truly spherical shape having the same volume.

The quantum dot may be coated with a resin.

The content of the quantum dot is appropriately adjusted according to the thickness of the phosphor layer, the recycling rate of light in the backlight, the target color, or the like. If the thickness of the phosphor layer is in the range described later, the content of the quantum dot is preferably 0.01 parts by mass or more and 1.0 part by mass or less per 100 parts by mass of the sealing resin of the phosphor layer.

Examples of the sealing resin of the phosphor layer include a cured product of a thermosetting resin composition, and a cured product of an ionizing radiation curable resin composition. Among these, in view of durability, a cured product of a thermosetting resin composition and a cured product of an ionizing radiation curable resin composition are preferable, and a cured product of an ionizing radiation curable resin composition is more preferable.

The thermosetting resin composition is a composition including at least a thermosetting resin, and is a resin composition that is cured by heating. Examples of the thermosetting resin include an acrylic resin, a urethane resin, a phenol resin, a urea melamine resin, an epoxy resin, an unsaturated polyester resin, and a silicone resin. These may be used singly or as a mixture of one or more. In the thermosetting resin composition, a curing agent is added, as necessary, to these curable resins.

The ionizing radiation curable resin composition is a composition including a compound having an ionizing radiation curable functional group (hereinafter, also referred to as an "ionizing radiation curable compound").

Examples of the ionizing radiation curable functional group include an ethylenically unsaturated bond group such as a (meth)acryloyl group, a vinyl group, or an allyl group, an epoxy group, and an oxetanyl group, and among these, an ethylenically unsaturated bond group is preferable. Among the ethylenically unsaturated bond groups, a (meth)acryloyl group is preferable. Hereinafter, the ionizing radiation curable compound having a (meth)acryloyl group is referred to as a (meth)acrylate-based compound. That is, the sealing resin preferably includes a cured product of a composition including a (meth)acrylate-based compound.

As used herein, "(meth)acrylate" refers to methacrylate and acrylate. As used herein, "ionizing radiation" means an electromagnetic wave or a charged particle beam having an energy quantum that can polymerize or crosslink a molecule among electromagnetic waves or charged particle beams. An ultraviolet ray (UV) or an electron beam (EB) is usually used, and an electromagnetic wave such as an X-ray or a γ-ray, and a charged particle beam such as an α-ray or an ion beam can also be used.

The ionizing radiation curable compound may be a monofunctional ionizing radiation curable compound having only one such functional group, a polyfunctional ionizing radiation curable compound having two or more such functional groups, or a mixture thereof. Among these, a polyfunctional ionizing radiation curable compound is preferable, and a polyfunctional (meth)acrylate-based compound having two or more (meth)acryloyl groups is more preferable. That is, the sealing resin includes preferably a cured product of a polyfunctional ionizing radiation curable compound and more preferably a cured product of a polyfunctional (meth)acrylate-based compound.

The polyfunctional (meth)acrylate-based compound may have an alkyleneoxy group.

As the alkyleneoxy group, for example, an alkyleneoxy group having 2 to 4 carbon atoms is preferable, an alkyleneoxy group having 2 or 3 carbon atoms is more preferable, and an alkyleneoxy group having 2 carbon atoms is further preferable.

The polyfunctional (meth)acrylate-based compound having an alkyleneoxy group may be a polyfunctional (meth)acrylate-based compound having a polyalkyleneoxy group including a plurality of alkyleneoxy groups.

When the polyfunctional (meth)acrylate-based compound has an alkyleneoxy group, the number of alkyleneoxy groups in one molecule is preferably 2 to 30, and more preferably 2 to 20, further preferably 3 to 10, and more further preferably 3 to 5.

When the polyfunctional (meth)acrylate-based compound has an alkyleneoxy group, the compound preferably has a bisphenol structure. This tends to improve the heat resistance of the cured product. Examples of the bisphenol structure include a bisphenol A structure and a bisphenol F structure, and among these, a bisphenol A structure is preferable.

As the polyfunctional (meth)acrylate-based compound having an alkyleneoxy group, above all, ethoxylated bisphenol A type di(meth)acrylate, propoxylated bisphenol A type di(meth)acrylate, and propoxylated ethoxylated bisphenol A type di(meth)acrylate are preferable, and ethoxylated bisphenol A type di(meth)acrylate is more preferable.

The ionizing radiation curable compound may be a monomer, an oligomer, a low molecular weight polymer, or a mixture thereof.

When the ionizing radiation curable compound is an ultraviolet curable compound, the ionizing radiation curable composition preferably includes an additive such as a photopolymerization initiator or a photopolymerization accelerator.

The phosphor layer may include an internal diffusion particle.

As the internal diffusion particle, either of an organic particle and an inorganic particle can be used. Examples of the organic particle include a particle made of polymethyl methacrylate, an acrylic-styrene copolymer, a melamine resin, a polycarbonate, a polystyrene, polyvinyl chloride, a benzoguanamine-melamine-formaldehyde condensate, a silicone resin, a fluororesin, a polyester, or the like. Examples of the inorganic fine particle include a fine particle made of silica, alumina, zirconia, titania, or the like.

Examples of the shape of the internal diffusion particle include a spherical shape, a disk shape, a rugby ball shape, and an irregular shape. The internal diffusion particle may be any of a hollow particle, a porous particle, and a solid particle.

The content of the internal diffusion particle is preferably 1 part by mass or more and 40 parts by mass or less and more preferably 3 parts by mass or more and 30 parts by mass or less per 100 parts by mass of the sealing resin.

The average particle size of the internal diffusion particle is preferably 1 µm or more and 7 µm or less and more preferably 1 µm or more and 3 µm or less.

The thickness of the phosphor layer is preferably 10 µm or more and 200 µm or less, more preferably 20 µm or more and 150 µm or less, and further preferably 30 µm or more and 130 µm or less.

### [Method for producing wavelength conversion sheet]

The wavelength conversion sheet of the present disclosure can be produced by using at least one film for a wavelength conversion sheet produced by the method for producing the film for a wavelength conversion sheet described above. In the following, a method for producing a wavelength conversion sheet having a configuration in which a phosphor layer is sandwiched between the films for a wavelength conversion sheet of the present disclosure, as shown in Fig. 2, will be given as an example.

Specifically, a liquid mixture (ink) including a phosphor and a sealing resin is applied to a surface of the primer layer of one film for a wavelength conversion sheet of the present disclosure. Examples of the method for applying the liquid mixture (ink) include an application method of roll coating, gravure coating, knife coating, dip coating, spray coating, or another coating method.

Then, the phosphor layer is contacted with the primer layer of another film for a wavelength conversion sheet of the present disclosure. After that, the liquid mixture (ink) is cured by heat or the like to obtain a wavelength conversion sheet.

### [Backlight]

The backlight of the present disclosure is a backlight including at least one light source that emits primary light, an optical plate that is disposed adjacent to the light source and is for light guiding or diffusion, and a wavelength conversion sheet (quantum dot sheet) disposed on a light emission side of the optical plate, wherein the wavelength conversion sheet is the wavelength conversion sheet of the present disclosure described above.

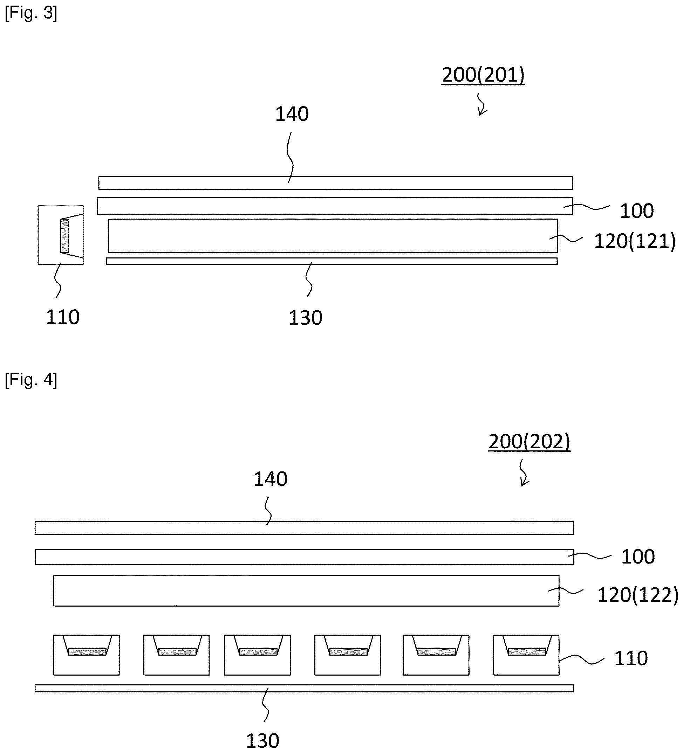

As a backlight 200 of the present disclosure, either the edge-lit type backlight shown in Fig. 3 or the direct-lit type backlight shown in Fig. 4 can be adopted.

An optical plate 120 used for the edge-lit type backlight 201 in Fig. 3 is an optical member for guiding primary light emitted by a light source 110, and is a so-called light guide plate 121. The light guide plate 121 has, for example, a substantially flat plate shape configured to have at least one surface as a light coming-in surface and one surface substantially orthogonal to the light coming-in surface as a light emission surface.

The light guide plate is mainly made of a matrix resin selected from the group consisting of a highly transparent resin such as polymethyl methacrylate. A resin particle having a refractive index different from that of the matrix resin may be added, as necessary, to the light guide plate. Each surface of the light guide plate may have a complicated surface shape instead of a uniform flat surface, and may be provided with a dot pattern or the like.

The optical plate 120 used for the direct-lit type backlight 202 of Fig. 4 is an optical member (light diffusing material 122) having a light diffusing property for making the pattern of the light source 110 less visible. Examples of the light diffusing material 122 include a milky white resin plate having a thickness of about 1 to 3 mm.

In addition to the light source, the optical plate, and the wavelength conversion sheet described above, the edge-lit type and direct-lit type backlights may include one or more members selected from a reflector, a light diffusing film, a prism sheet, a brightness enhancement film (BEF), a reflective polarizing film (DBEF), and the like, depending on the purpose. The reflector is disposed on the opposite side of the optical plate from the light emission surface side. The light diffusing film, the prism sheet, the brightness enhancement film, and the reflective polarizing film are disposed on the light emission surface side of the optical plate. A backlight having an excellent balance of front brightness, viewing angle, and the like can be provided when the backlight is configured to include one or more members selected from the group consisting of a reflector, a light diffusing film, a prism sheet, a brightness enhancement film, a reflective polarizing film, and the like.

In the edge-lit type and direct-lit type backlights, the light source 110 is a light emitting body that emits primary light, and it is preferable to use a light emitting body that emits primary light having a wavelength corresponding to blue. The primary light having a wavelength corresponding to blue preferably has a peak wavelength in the range of 380 nm to 480 nm. The peak wavelength is more preferably 450 nm ± 7 nm, more preferably 450 nm ± 5 nm, more preferably 450 nm ± 3 nm, and more preferably 450 nm ± 1 nm.

The light source 110 is preferably an LED light source and more preferably a blue monochromatic LED light source, in view of simplifying and downsizing the apparatus in which the backlight is installed. Alternatively, a red phosphor may be applied onto a blue monochromatic LED light source to provide a light source that exhibits a blue color and a red color. The number of the light source 110 is at least one, and it is preferable to provide a plurality thereof, in view of emitting sufficient primary light.

### [Display device]

Examples of the display device include a liquid crystal display device. The liquid crystal display device includes a backlight and a liquid crystal panel. The backlight is the backlight of the present disclosure described above.

The liquid crystal panel is not particularly limited, and a general-purpose liquid crystal panel can be used as the liquid crystal panel of the liquid crystal display device. For example, a liquid crystal panel having a general structure can be used in which the liquid crystal layer is sandwiched between glass plates on the upper side and the lower side, respectively, thereof, specifically, a liquid crystal panel using a display mode such as TN, STN, VA, IPS, and OCB.

The liquid crystal display device further includes a polarizing plate, a color filter, and the like. A general-purpose polarizing plate and color filter can be used.

The wavelength conversion sheet of the present disclosure has particularly excellent close adhesion between the film for a wavelength conversion sheet and the phosphor layer. Therefore, when the wavelength conversion sheet of the present disclosure is applied to a display device (liquid crystal display device), degradation of the phosphor layer due to the invasion thereof by water vapor or oxygen from the external environment can be effectively suppressed. As a result, a display device including a backlight light source having excellent environmental stability can be obtained.

### Examples

Next, the present disclosure will be described in more detail with Examples, but the present disclosure is not limited by these Examples at all.

### 1. Evaluations and measurements

The film for a wavelength conversion sheet and the wavelength conversion sheet produced by the following production methods were subjected to the following measurements and evaluations. Results are shown in Table 1. Unless otherwise specified and unless the test was carried out in a specific environment, the atmosphere at the time of each measurement and evaluation was a temperature of 23 ± 5°C and a relative humidity of 40 to 65%, and before the start of each measurement and evaluation, the target sample was exposed to the above atmosphere for 30 minutes or more and then the measurement and evaluation were carried out.

### 1-1. Measurement of softening point

Of the films for a wavelength conversion sheet of Examples and Comparative Examples, a softening point of the primer layer was measured by the following step.

As a measuring apparatus, nanoTA, available from ANASYS INSTRUMENTS Corp., was used. As a thermal probe, PR-EX-AN2-300-5, available from ANASYS INSTRUMENTS Corp., was used.

Before the measurement, calibration was performed by the following step.

As a standard sample, nanoTA Calibration Samples, available form BRUKER were prepared. The standard sample set contains polycaprolactone (softening point: 55°C), polyethylene (softening point: 116°C), and polyethylene terephthalate (softening point: 235°C), which had known softening points. Each of the standard samples was heated while contacting the thermal probe on the surface of each of the standard samples. During the heating, thermal expansion directly under the thermal probe was measured to obtain a graph indicating deflection relative to voltage. The measurement conditions set with the apparatus were as follows.
Measurement starting temperature: 0.1 V
Measurement ending temperature: 10 V
Heating rate: 0.2 V/sec

By using the softening point of each of the standard samples, the graph indicating the deflection of the thermal probe relative to the voltage was converted into a graph indicating the deflection relative to the temperature.

After the calibration, on the films for a wavelength conversion sheet of Examples and Comparative Examples, the thermal probe was contacted with the primer layer surface. Thereafter, in a state where the thermal probe was contacted, the film for a wavelength conversion sheet was heated under the following conditions to obtain a graph indicating deflection of the thermal probe relative to temperature (thermal expansion curve). When the surface of the primer layer is not exposed, the primer layer may be measured from a cross section formed by embedding the sample into a resin and then forming the cross section with a diamond knife available from DiATOME Ltd.
Measurement starting temperature: 40°C
Measurement ending temperature: 350°C
Heating rate: 5°C/sec

In the obtained thermal expansion curve, a temperature at the top of the curve was obtained. The above measurement was performed at any ten points on the primer layer surface of the films for a wavelength conversion sheet of Examples and Comparative Examples. An average value of the obtained temperatures was regarded as the softening point. Results are shown in Table 1.

### 1-2. Evaluation of initial close adhesion

The wavelength conversion sheets of Examples and Comparative Examples were produced, and then a test piece with 25 mm × 150 mm was cut from any three points of the wavelength conversion sheet. By using a desktop material tester (STA-1150, available from Takachiho-Seiki. Co., Ltd.), a peeling test was performed under conditions of a tension speed of 300 mm/min, a peeling direction of 180°, and a distance between chucks of 15 mm in a temperature environment of 23°C, and the peel strength between the film for a wavelength conversion sheet (primer layer) and the phosphor layer was measured for each test piece. An average value of the obtained peel strength was regarded as the initial peel strength (before a high-temperature high-humidity test). Results are shown in Table 1.

### 1-3. Evaluation of temporal close adhesion

The wavelength conversion sheets of Examples and Comparative Examples were placed in a thermohygrostat bath adjusted to 60°C and 90%RH. After 250 hours and 500 hours had passed, the wavelength conversion sheets were taken out of the thermohygrostat bath.

On the taken wavelength conversion sheets, the peel strength of each test piece was measured according to the procedures in 1-2. An average value of the peel strength of the test piece obtained at any three points was used as the peel strength after each time had passed. Results are shown in Table 1.

### 2. Preparation of sample

### 2-1. Preparation of film for wavelength conversion sheet

### <Example 1>

As a first base material, an aluminum oxide thin film (AlOx, target thickness: 8 nm) was vapor-deposited on a PET film (thickness: 12 µm) by a vacuum vapor deposition method to form an inorganic oxide layer.

Tetraethoxysilane was mixed into a solution (pH 2.2) obtained by mixing water, isopropyl alcohol, and 0.5 N hydrochloric acid, while cooling the solution to 10°C, to thereby prepare solution A. Separately, polyvinyl alcohol having a saponification value of 99% or more and isopropyl alcohol were mixed to thereby prepare solution B. Solution A and solution B were mixed to prepare the coating liquid for organic coating layer formation (solid content: 5%).

Next, the coating liquid for organic coating layer formation was applied onto the inorganic oxide layer by gravure printing and heat-treated at 180°C for 60 seconds to form an organic coating layer having a thickness of 180 nm.

Then, a coating liquid for primer layer formation having the following formulation was prepared. The coating liquid had NCO/OH ratio of 1.3.
- Acrylic polyol resin 1 50 parts by mass
- Modified polyisocyanate having acryl group 80 parts by mass
- Silane coupling agent (3-glycidoxypropyltrimethoxysilane) 2.0 parts by mass
- Silica powder (average particle size of 3 µm) 2.0 parts by mass

Next, the coating liquid for primer layer formation was applied onto the organic coating layer. The amount of the applied coating liquid was 0.5 g/m². Thereafter, the coating was dried at 80°C for 60 seconds to form a primer layer having a thickness of 0.4 µm.

A urethane-based adhesive (manufactured by Rock Paint Co., Ltd., trade name "RU-004, H-1") was applied, by gravure printing, onto the surface of the opposite side of the first base material from the surface on which the inorganic oxide layer to the primer layer were formed, and dried to form an adhesion layer having a thickness of 4 µm.

Next, a PET film (thickness: 100 µm) was disposed as a second base material on the adhesion layer side of the first base material, and the first base material and the second base material were bonded together under conditions of nip pressure: 0.2 MPa and line speed: 50 m/min to prepare a film for a wavelength conversion sheet of Example 1.

### <Example 2>

A barrier film of Example 2 was prepared in the same step as in Example 1 except that a coating liquid for primer layer formation having the following formulation was used. The coating liquid had NCO/OH ratio of 1.3. The amount of the applied coating liquid was 0.5 g/m².
- Acrylic polyol resin 1 40 parts by mass
- Polyester urethane-based resin 20 parts by mass
- Modified polyisocyanate having acryl group 70 parts by mass
- Silane coupling agent (3-glycidoxypropyltrimethoxysilane) 2.0 parts by mass
- Silica powder (average particle size of 3 µm) 2.0 parts by mass

### <Example 3>

A barrier film of Example 3 was prepared in the same step as in Example 1 except that a coating liquid for primer layer formation having the following formulation was used. The coating liquid had NCO/OH ratio of 4.0. The amount of the applied coating liquid was 0.5 g/m².
- Acrylic polyol resin 1 15 parts by mass
- Polyester urethane-based resin 20 parts by mass
- Modified polyisocyanate having acryl group 60 parts by mass
- Silane coupling agent (3-glycidoxypropyltrimethoxysilane) 2.0 parts by mass
- Silica powder (average particle size of 3 µm) 2.0 parts by mass

### <Example 4>

A barrier film of Example 4 was prepared in the same step as in Example 1 except that a coating liquid for primer layer formation having the following formulation was used. The coating liquid had NCO/OH ratio of 1.3. The amount of the applied coating liquid was 0.5 g/m². The acrylic polyol resin 2 was a resin having larger molecular weight than the acrylic polyol resin 1.
- Acrylic polyol resin 2 30 parts by mass
- Polyester urethane-based resin 20 parts by mass
- Modified polyisocyanate having acryl group 40 parts by mass
- Silane coupling agent (3-glycidoxypropyltrimethoxysilane) 2.0 parts by mass
- Silica powder (average particle size of 3 µm) 2.0 parts by mass

### <Example 5>

A barrier film of Example 5 was prepared in the same step as in Example 1 except that a coating liquid for primer layer formation having the following formulation was used. The coating liquid had NCO/OH ratio of 4.0. The amount of the applied coating liquid was 0.5 g/m².
- Acrylic polyol resin 2 10 parts by mass
- Polyester urethane-based resin 20 parts by mass
- Modified polyisocyanate having acryl group 30 parts by mass
- Silane coupling agent (3-glycidoxypropyltrimethoxysilane) 2.0 parts by mass
- Silica powder (average particle size of 3 µm) 2.0 parts by mass

### <Comparative Example 1>

A barrier film of Comparative Example 1 was prepared in the same step as in Example 1 except that a coating liquid for primer layer formation having the following formulation was used. The coating liquid had NCO/OH ratio of 1.3. The amount of the applied coating liquid was 0.5 g/m².
- Polyester urethane-based resin 20 parts by mass
- Modified polyisocyanate having acryl group 5 parts by mass
- Silane coupling agent (3-glycidoxypropyltrimethoxysilane) 2.0 parts by mass
- Silica powder (average particle size of 3 µm) 2.0 parts by mass

### <Comparative Example 2>

A barrier film of Comparative Example 2 was prepared in the same step as in Example 1 except that a coating liquid for primer layer formation having the following formulation was used. The coating liquid had NCO/OH ratio of 8.0. The amount of the applied coating liquid was 0.5 g/m².
- Polyester urethane-based resin 20 parts by mass
- Modified polyisocyanate having acryl group 30 parts by mass
- Silane coupling agent (3-glycidoxypropyltrimethoxysilane) 2.0 parts by mass
- Silica powder (average particle size of 3 µm) 2.0 parts by mass

### <Comparative Example 3>

A barrier film of Comparative Example 3 was prepared in the same step as in Example 1 except that a coating liquid for primer layer formation having the following formulation was used. The coating liquid had NCO/OH ratio of 1.3. The amount of the applied coating liquid was 0.5 g/m².
- Acrylic polyol resin 1 15 parts by mass
- Polyester urethane-based resin 20 parts by mass
- Modified polyisocyanate having acryl group 20 parts by mass
- Silane coupling agent (3-glycidoxypropyltrimethoxysilane) 2.0 parts by mass
- Silica powder (average particle size of 3 µm) 2.0 parts by mass

### <Comparative Example 4>

A barrier film of Comparative Example 4 was prepared in the same step as in Example 1 except that a coating liquid for primer layer formation having the following formulation was used. The coating liquid had NCO/OH ratio of 1.3. The amount of the applied coating liquid was 0.5 g/m².
- Acrylic polyol resin 2 10 parts by mass
- Polyester urethane-based resin 20 parts by mass
- Modified polyisocyanate having acryl group 10 parts by mass
- Silane coupling agent (3-glycidoxypropyltrimethoxysilane) 2.0 parts by mass
- Silica powder (average particle size of 3 µm) 2.0 parts by mass

### <Comparative Example 5>

A barrier film of Comparative Example 5 was prepared in the same step as in Example 1 except that a coating liquid for primer layer formation having the following formulation was used. The coating liquid had NCO/OH ratio of 4.0. The amount of the applied coating liquid was 0.5 g/m².
- Acrylic polyol resin 1 15 parts by mass
- Polyester urethane-based resin 20 parts by mass
- Modified polyisocyanate having no acryl group 40 parts by mass
- Silane coupling agent (3-glycidoxypropyltrimethoxysilane) 2.0 parts by mass
- Silica powder (average particle size of 3 µm) 2.0 parts by mass

### 2-2. Preparation of wavelength conversion sheet

A sealing resin (ionizing radiation curable urethane acrylate-based resin) was mixed into a phosphor (quantum dot having an average particle size of 3 to 5 nm) having a core made of cadmium selenide (CdSe) and a shell made of zinc sulfide (ZnS) such that the amount of the phosphor was 1 part by mass per 100 parts by mass of the sealing resin, to prepare a liquid mixture (ink) for phosphor layer formation.

The ink was applied onto the primer layer of the film for a wavelength conversion sheet of each of the Examples and the Comparative Examples in such a way as to have a thickness of 100 µm (after drying) to form a phosphor layer.

Another film for a wavelength conversion sheet of Examples and Comparative Example (same as the barrier film on which the ink was applied, respectively) was laminated on the phosphor layer such that the primer layer was in contact with the phosphor layer. Thereafter, the sealing resin of the phosphor layer was UV-cured to produce wavelength conversion sheets of Examples 1 to 5 and Comparative Examples 1 to 5.

### 3. Results

**Table 1**

| | Softening point (°C) | Close adhesion (N) | | |
|---|---|---|---|---|
| | | Initial | After 250 hours | After 500 hours |
| Example 1 | >350 | 7.9 | 8.2 | 7.6 |
| Example 2 | 280.1 | 7.2 | 7.5 | 5.3 |
| Example 3 | 288.9 | 7.4 | 8.2 | 5.8 |
| Example 4 | >350 | 8 | 8.2 | 6.1 |
| Example 5 | 279.5 | 7.8 | 8.1 | 5.4 |
| Comparative Example 1 | 96.4 | 6.8 | 0.3 | 0.1 |
| Comparative Example 2 | 230.3 | 7.7 | 1.1 | 0.3 |
| Comparative Example 3 | 246.1 | 7.5 | 1.4 | 0.4 |
| Comparative Example 4 | 235.7 | 7.7 | 1.3 | 0.3 |
| Comparative Example 5 | 245.9 | 5.5 | 0.2 | 0.1 |

The top of the curve was not observed within the measurement temperature range in Examples 1 and 4. That is, the primer layers of Examples 1 and 4 were judged to have a softening point of the cured product of the resin composition of higher than 350°C.

In all of Examples 1 to 5, the softening point of the cured product of the resin composition of the primer layer was 250°C or higher. In the wavelength conversion sheets of Examples 1 to 5, the close adhesion after 250 hours was improved from the initial close adhesion. The high close adhesion was retained even after 500 hours.

In contrast, Comparative Examples 1 to 5 exhibited a low softening point of the cured product of the resin composition of the primer layer. The wavelength conversion sheets of Comparative Examples 1 to 5 exhibited the initial close adhesion similar to that of Examples 1 to 5, but the close adhesion after 250 hours was considerably decreased.

### Reference Signs List

10 (10a, 10b): Film for wavelength conversion sheet
20: Base material layer
20-1: First base material
20-2: Second base material
22: Adhesive layer
30: Primer layer
40: Barrier layer
42: Inorganic oxide layer
44: Organic coating layer
50: Diffusion layer
60: Phosphor layer
100: Wavelength conversion sheet
110: Light source
120: Optical plate
121: Light guide plate
122: Diffusing plate
130: Reflector
140: Prism sheet
200: Backlight
201: Edge-lit type backlight
202: Direct-lit type backlight

## Claims

1. A film for a wavelength conversion sheet, comprising: a base material; and a primer layer on the base material, wherein
the primer layer comprises a cured product of a resin composition comprising a polyurethane-based resin, and the cured product has a softening point of 250°C or higher.

2. The film for a wavelength conversion sheet according to claim 1, wherein the resin composition has a mole ratio of isocyanate groups to hydroxyl groups (NCO/OH ratio) of 1.1 or more.

3. The film for a wavelength conversion sheet according to claim 1 or 2, wherein the polyurethane-based resin comprises a polyurethane-based resin obtained by a reaction between a polyfunctional isocyanate having a (meth)acryl group and a hydroxyl group-containing compound.

4. The film for a wavelength conversion sheet according to any one of claims 1 to 3, wherein the resin composition comprises a silane coupling agent.

5. The film for a wavelength conversion sheet according to any one of claims 1 to 4, further comprising a barrier layer between the base material and the primer layer.

6. The film for a wavelength conversion sheet according to claim 5, wherein the barrier layer comprises an inorganic oxide layer and an organic coating layer, and the organic coating layer is in contact with the primer layer.

7. The film for a wavelength conversion sheet according to claim 5, wherein the barrier layer is a layer comprising a reaction product of a composition comprising a metal oxide and a phosphorus compound.

8. A wavelength conversion sheet, wherein the film according to any one of claims 1 to 7 is provided on at least one surface side of a phosphor layer comprising a phosphor such that the primer layer and the phosphor layer are in contact with each other.

9. A backlight comprising: at least one light source that emits primary light; an optical plate that is disposed adjacent to the light source and is for light guiding or diffusion; and a wavelength conversion sheet disposed on a light emission side of the optical plate, wherein
the wavelength conversion sheet is the wavelength conversion sheet according to claim 8.

10. A display device comprising: a backlight; and a liquid crystal panel, wherein the backlight is the backlight according to claim 9.
